(19) Europäisches Patentamt
European Patent Office
Office européen des brevets

(11) **EP 2 838 333 B1**

(12) # EUROPEAN PATENT SPECIFICATION

(45) Date of publication and mention
of the grant of the patent:
**21.08.2019 Bulletin 2019/34**

(51) Int Cl.:
***H05K 13/04*** *(2006.01)*   ***G01N 21/956*** *(2006.01)*

(21) Application number: **13775076.6**

(22) Date of filing: **24.01.2013**

(86) International application number:
**PCT/JP2013/051503**

(87) International publication number:
**WO 2013/153834 (17.10.2013 Gazette 2013/42)**

(54) **COMPONENT MOUNTING MACHINE**

MASCHINE ZUR MONTAGE VON KOMPONENTEN

MACHINE DE MONTAGE DE COMPOSANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.04.2012 PCT/JP2012/059965
01.08.2012 PCT/JP2012/069630
21.11.2012 PCT/JP2012/080167**

(43) Date of publication of application:
**18.02.2015 Bulletin 2015/08**

(73) Proprietor: **FUJI Corporation
Chiryu
Aichi (JP)**

(72) Inventors:
• **YAMAKAGE Yusuke**
**Chiryu, Aichi (JP)**

• **YOSHINO Tomoharu**
**Chiryu, Aichi (JP)**

(74) Representative: **Grünecker Patent- und
Rechtsanwälte
PartG mbB
Leopoldstraße 4
80802 München (DE)**

(56) References cited:
**WO-A1-2004/046643    WO-A2-02/17357
JP-A- 2002 094 296    JP-A- 2002 144 267
JP-A- 2004 172 465    JP-A- 2008 021 734
JP-A- 2008 205 134    JP-A- 2011 165 865
JP-A- 2011 233 674    US-A1- 2002 031 279**

## Description

### Technical Field

The present invention relates to a component-mounting machine which is able to capture images of an imaging reference mark provided on a component-mounting head and a component sucked by a suction nozzle simultaneously to detect a position of the sucked component with respect to the imaging reference mark.

### Background Art

A component-mounting machine captures images of an imaging reference mark provided on a component-mounting head and a sucked component simultaneously, and detects positional displacement or angle deviation of the sucked component from the captured image. The component-mounting machine further corrects a mounting position of the sucked component based on a detected result, such as the positional displacement and the angle deviation.

Moreover, in the component-mounting machine, the component-mounting head is designed to move at a high speed in order to shorten the time needed for mounting components. When the component-mounting head moves very fast, exposure time of imaging is shortened. Therefore, it is necessary to open the aperture of the camera to increase an amount of light received by the camera. However, if the aperture is opened, the camera has a shallow depth of field, and thus it is difficult to focus on both the imaging reference mark and the sucked component. It is the same when sucked components having different thickness are imaged simultaneously.

As an invention related to such a task, for example, inventions described in Patent Literatures 1 and 2 are known. A position detection device described in PTL 1 is provided with a position marking device and an optical imaging device on a mounting head side above a component sucked by a suction pipette, and is provided with a ground glass adjacent to the component. The position marking device is projected on the ground glass through the optical imaging device to capture images of the position marking device and the component.

A surface mounting machine related to a first invention described in PTL 2 includes a reference mark and a lens at a position higher than a focal position of a camera. The lens is able to extend the focal position of the camera upwardly up to the height of the reference mark. Furthermore, a surface mounting machine related to a second invention described in PTL 2 includes a lens which focuses the camera on the reference mark and is provided on a camera side. The machine also includes an actuator which moves the lens in an imaging range of the camera when the reference mark passes above the camera, and puts the lens outside the imaging range of the camera when a component for mounting passes above the camera. Moreover, the camera described in PTL 2 uses a CCD linear sensor as an image sensor, which is able to image the component for mounting or the reference mark one-dimensionally.

PTL 3 which is regarded as the closest prior art discloses an electric-component handling device comprising a suction pipe having a suction nozzle and an image taking device having a CCD camera which captures images of a fiducial mark being provided by the free or lower end face of a pin.

PTL 4 employs an imaging device for simultaneously acquiring front and side view images of electronic components sucked by a plurality of concentrically arranged suction nozzles. A reflector is disposed at the center of the suction nozzle, and has a reflective surface tilted at 45 degrees. Light from the side of the electronic component is reflected downward from the reflective surface and focused on the imaging surface of a CCD image sensor so as to form a side view image.

PTL 5 discloses an optical inspection system for inspecting an IC component. The IC component is positioned in an overlapping relationship with an aperture of a datum and illuminated by a lateral diffuse light source, thereby projecting contour images of the IC component and of a reference contour of the reference edge through the aperture in several projection directions.

### Citation List

### Patent Literature

PTL 1: JP 2001 518723 A
PTL 2: JP 2005 197564 A
PTL 3: US 2002/031279 A1
PTL 4: WO 2004/046643 A1
PTL 5: WO 02/17352 A2

### Summary of Invention

### Technical Problem

However, in the invention described in PTL 1, the mounting head has a complex structure since the optical imaging device is provided on the mounting head side, and thus the mounting head gets bigger and heavier. The optical imaging device or the ground glass is likely to collide with the component when the mounting head moves. Regarding the former, the first invention described in PTL 2 has the same problem.

The second invention described in PTL 2 moves the lens in or out of the imaging range of the camera. Thus it is impossible to capture images of the reference mark and the component for mounting simultaneously. Also, the second invention described in PTL 2 needs to drive the actuator along with the movement of a head unit having the reference mark, thus the control becomes quite complex.

Furthermore, the camera described in PTL 2 uses the CCD linear sensor as the image sensor, therefore the camera cannot capture images two-dimensionally. For example, in the rotary head, a plurality of the suction nozzles is rotatably held on a circumference of a circle concentrically provided with an axis line, and the component for mounting is sucked and held by each of the suction nozzles. In this case, the CCD linear sensor cannot- capture images of the reference mark and a plurality of the components for mounting simultaneously.

The present invention is made in consideration of such problems, to provide a component-mounting machine which prevents collision of a sucked component with an optical system capturing images of an imaging reference mark and the sucked component simultaneously when a component-mounting head moves to capture images while lighting the component-mounting head.

Solution to Problem

A component-mounting machine described in claim 1, according to the present invention, solves the above mentioned problems.
Further embodiments are provided in dependent claims 2-5.

Advantageous Effects of Invention

According to the component-mounting machine described in claim 1, the sucked-component position detection device includes the first refraction member which alters the focal position of the first optical path that connects the image sensor, the lens and the imaging reference mark. Therefore, it is possible to alter the focal position of the first optical path with respect to the imaging reference mark arranged at a height different from that of the sucked component, and to focus on both the imaging reference mark and the sucked component. Moreover, since the first refraction member is provided at a position lower than the focal position of the second optical path that connects the image sensor, the lens and the sucked component, the first refraction member and the sucked component do not collide with each other when the component-mounting head moves to capture images. Therefore, it is not necessary to provide a mechanism for preventing collision of the first refraction member with the sucked component, thereby downsizing the sucked-component position detection device. Moreover, since the first refraction member is provided on the base side of the component-mounting machine, a configuration of the component-mounting head can be further simplified as compared with a case in which the first refraction member is provided on the component-mounting head side, thereby lightening the component-mounting head.

According to the component-mounting machine described in claim 2, since the second refraction member is provided to alter the focal position of the second optical path, it is possible to alter the focal position of the second optical path in accordance with a height of the sucked component. Moreover, since the second refraction member is provided on the base side and at a position lower than the focal position of the second optical path, it is possible to obtain a similar effect to the aforementioned effect of the first refraction member.

According to the component-mounting machine described in claim 3, the plurality of the second refraction members is concentrically arranged in accordance with a height of the sucked components on the plurality of the component-mounting heads having different circumferential diameters around which the suction nozzles rotate. Therefore, it is possible to set the focal position of the second optical path in accordance with a height of the sucked component of each component-mounting head, respectively. Moreover, it is unnecessary to replace the second refraction member every time the component-mounting head is replaced, thereby decreasing manhours.

According to the component-mounting machine described in claim 4, the first refraction member is provided on the imaging unit side than the light source that irradiates the imaging reference mark and the sucked component with light. Therefore, it is possible to prevent the light, emitted from the light source, from being guided directly to the first refraction member and being reflected by the first refraction member. Thus, it is possible to prevent the reflective light from causing an adverse effect on imaging of the imaging reference mark and the sucked component.

According to the component-mounting machine described in claim 5, the imaging unit has an aperture which is set such that, out of reflective light emitted from the light source and reflected by the imaging reference mark and the sucked component, mainly light parallel to a height direction of the component-mounting machine arrives at the image sensor. Therefore, it is possible to suppress a ghost occurrence in the captured images of the imaging reference mark and the sucked component, thereby preventing false recognition when the positions of the imaging reference mark and the sucked component are recognized.

Brief Description of Drawings

Fig. 1 is a perspective view expressing an example of the component-mounting machine.
Fig. 2 is a configuration diagram schematically expressing an example of the sucked-component position detection device.
Fig. 3 is an explanation diagram illustrating a change in length of the optical path depending on the presence or absence of the first refraction member.
Fig. 4 is a plan view illustrating a state in what three second refraction members are concentrically arranged.

Fig. 5 is an explanation diagram illustrating a correlation between transmission of reflective light and the aperture of the imaging unit.

Description of Embodiments

Hereinafter, embodiments of the present invention will be described based on accompanying drawings. Each diagram is a conceptual diagram, and does not define the size of detailed structures.

(1) Component-mounting Machine

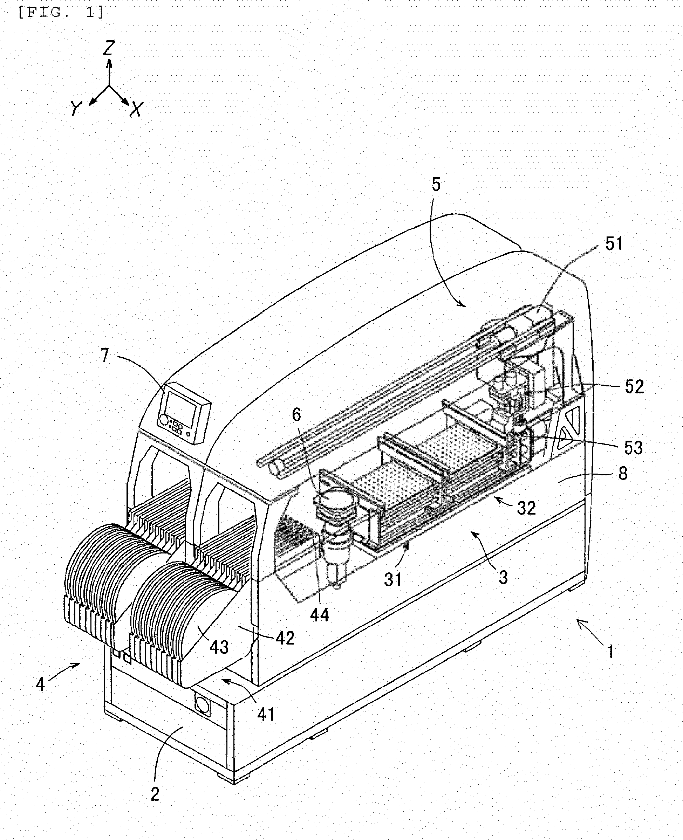

Fig. 1 is a perspective view expressing an example of the component-mounting machine. In Fig. 1, a conveying direction of the substrate is a traverse direction (indicated by arrow X), and a direction perpendicular to the traverse direction (indicated by arrow X) within a horizontal plane is a longitudinal direction (indicated by arrow Y). Moreover, a normal direction of the horizontal plane is a height direction (indicated by arrow Z). The component-mounting machine 1 includes a substrate conveying device 3, a component feeding device 4, a component transfer device 5, a sucked-component position detection device 6 and a control device 7, which are mounted on a base 8. The base 8 is movably loaded in the longitudinal direction (indicated by arrow Y) with respect to a system base 2.

The substrate conveying device 3 carries the substrate into and out of a mounting position. The substrate conveying device 3 is a so-called double conveyor type transfer device, which is installed around a center of the longitudinal direction (indicated by arrow Y) of the component-mounting machine 1, and in which a first conveying device 31 and a second conveying device 32 are arranged side by side. The first conveying device 31 has a pair of guide rails arranged parallel to the traverse direction (indicated by arrow X) on the base 8, and a pair of conveyor belts which is directed to the pair of the guide rails and transfers the substrate loaded thereon. The first conveying device 31 is provided with a clamp device (not shown), which positions the substrate transferred to the mounting position by lifting the substrate from a side of the base 8. The second conveying device 32 has a configuration similar to the first conveying device 31.

The component feeding device 4 is provided on a front end (left side of paper of Fig. 1) of the longitudinal direction (indicated by arrow Y) of the component-mounting machine 1, and has a plurality of cassette feeders 41 detachably mounted on a feeder holder. The feeder 41 includes a feeder main body 42, a feeding reel 43 which is rotatably and detachably mounted to the feeder main body 42, and a component feeding unit 44 which is installed on a tip side (near to the center of the component-mounting machine 1) of the feeder main body 42. The feeding reel 43 is a carrier for feeding the component, and includes a carrier tape (not shown) wound thereon, which holds a predetermined number of components at regular intervals. A front edge of the carrier tape is drawn to the component feeding unit 44, thereby feeding different component for each carrier tape. The feeder 41 is able to feed, for example, relatively small components such as a chip component.

The component transfer device 5 sucks the component from the component feeding device 4 to mount the component on the substrate carried into the mounting position. The component transfer device 5 is a so-called XY robot type transfer device, which is movable in the traverse direction (indicated by arrow X) and in the longitudinal direction (indicated by arrow Y). The component transfer device 5 is installed above the component feeding device 4 from a rear end (right back side of paper of Fig. 1) of the longitudinal direction (indicated by arrow Y) of the component-mounting machine 1 to a front end (left front side of paper of Fig. 1) of the same direction. The component transfer device 5 has a head driving mechanism 51 and a component-mounting head 52.

The head driving mechanism 51 is able to drive the component-mounting head 52 in the traverse direction (indicated by arrow X) and in the longitudinal direction (indicated by arrow Y). The component-mounting head 52 has a plurality of suction nozzles 53. Each of the suction nozzles 53 sucks the component by its apical portion to mount the component on the substrate carried into the mounting position. Moreover, since the first conveying device 31 and the second conveying device 32 alternately carry the substrate in and out, it is possible to alternately mount the component using the component transfer device 5.

The base 8, between the component feeding device 4 and the substrate conveying device 3, is provided with the sucked-component position detection device 6 thereon, which detects a held position of the component. The sucked-component position detection device 6 is able to detect positional displacement or angle deviation of the component (hereinafter "sucked component PA") sucked by the suction nozzle 53. The detection results, i.e. positional displacement and angle deviation, are used for calibrating the mounting position of the sucked component PA. The sucked-component position detection device 6 will hereinafter be described in detail.

The component-mounting machine 1 can be controlled by the control device 7 installed on a front upper part of a cover. The control device 7 has a CPU and a memory (both not shown), and is able to drive the component-mounting machine 1 by executing a component mounting program stored in the memory. That is, the control device 7 drives the substrate conveying device 3, the component feeding device 4, the component transfer device 5 and the sucked-component position detection device 6 on a basis of the component mounting program, thereby mounting the component on the substrate.

The head driving mechanism 51 is driven to cause the component-mounting head 52 to move to the component feeding device 4. The plurality of the suction nozzles 53 sucks the component, respectively. When every suction nozzle 53 has sucked the component, the head driving mechanism 51 is driven to cause the component-mounting head 52 to move. When the component-mounting head 52 arrives above the sucked-component position detection device 6, images of the sucked component PA and an imaging reference mark 5M (described later) are captured simultaneously. Then, the component-mounting head 52 moves above the substrate position at the predetermined position. At this time, a moving position of the component-mounting head 52 is calibrated based on positional displacement and angle deviation, which have been detected by the sucked-component position detection device 6. The component-mounting head 52 mounts the component on the substrate, and then returns back to the component feeding device 4. The component-mounting machine 1 is able to mount a plurality of the components on the substrate by repeating this series of operations.

(2) Sucked-component Position Detection Device

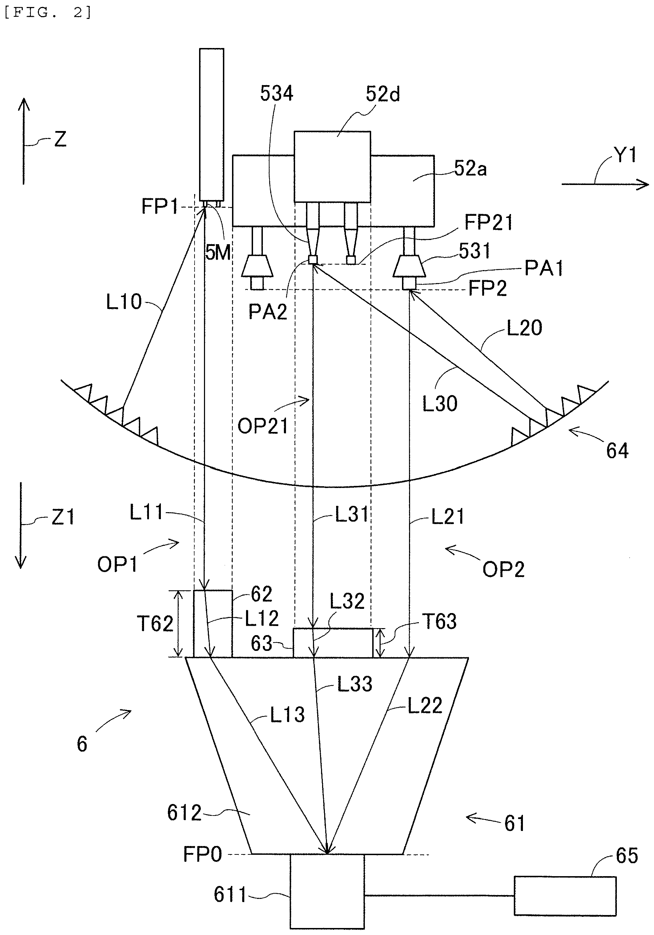

The sucked-component position detection device 6 detects a position of the sucked component PA with respect to the imaging reference mark 5M by simultaneously imaging the imaging reference mark 5M provided on the component-mounting head 52 and the sucked component PA sucked by the suction nozzle 53. Fig. 2 is a configuration diagram schematically expressing an example of the sucked-component position detection device. In Fig. 2, the component-mounting head 52 is installed as two component-mounting heads 52a and 52d, having different circumferential diameters around which the suction nozzles 53 rotate. The suction nozzle 53 of the component-mounting head 52a is indicated as the suction nozzle 531, and the sucked component PA sucked by the suction nozzle 531 is indicated as the sucked component PA1. Similarly, the suction nozzle 53 of the component-mounting head 52d is indicated as the suction nozzle 534, and the sucked component PA sucked by the suction nozzle 534 is indicated as the sucked component PA2. In the present description, the term of "sucked component PA" is properly used for illustrating a case in which the sucked components PA1 and PA2 are not distinguished.

The imaging reference mark 5M is a reflective member which reflects light emitted by a light source 64. A plurality of the imaging reference marks 5M (for example, four marks) are arranged in the traverse direction (indicated by arrow X) and in the longitudinal direction (indicated by arrow Y) at regular intervals. As shown in Fig. 2, the imaging reference marks 5M are installed on outer circumferential sides of the component-mounting heads 52a and 52d, and at a position higher than the sucked components PA1 and PA2 in the height direction (indicated by arrow Z). Therefore, it is possible to prevent the other components which have been mounted from colliding with the imaging reference marks 5M when the component-mounting head 52a and 52d move above the substrate. The sucked-component position detection device 6 includes an imaging unit 61, a first refraction member 62, a second refraction member 63, a light source 64 and an image processing unit 65. The image processing unit 65 may be installed in the control device 7.

(Imaging Unit 61)

The imaging unit 61 is installed on the side of the base 8 (a side of a direction indicated by arrow Z1 in Fig. 2) of the component-mounting machine 1 shown in Fig. 1. The imaging unit 61 uses, for example, a publicly-known CCD camera or a publicly-known CMOS camera. The imaging unit 61 has an image sensor 611, a lens 612, and an aperture 613. When the CCD camera is employed, the image sensor 611 is a charge-coupled device (CCD), and when the CMOS camera is employed, the image sensor 611 is a complementary metal oxide semiconductor (CMOS).

The image sensor 611 is a 2D image sensor, and is constituted of a plurality of light-receiving elements which is arranged in a plane. Therefore, the imaging unit 61 has a two-dimensional visual field. Thus, the imaging unit 61 is able to pick up the imaging reference mark 5M and the sucked component PA1 held by each of the rotating suction nozzles 531 in the same visual field, thereby simultaneously imaging the imaging reference mark 5M and the sucked component PA1. This configuration is not limited to the sucked component PA1, but can be employed for other sucked components PA.

As the lens 612, it is possible to use a publicly-known collecting lens, or to configure an optical system by combining a plurality of convex lenses and concave lenses. For example, the lens 612 uses an aspheric lens with decreased spherical aberration or a low dispersion lens which decreases chromatic aberration by lowering light dispersion. The focal length of the lens 612 is set such that the lens 612 focuses on the sucked component PA1. The sucked component PA1 is at the lowest position (height) in the height direction (indicated by arrow Z), among the sucked components PA.

(First Refraction Member 62)

The first refraction member 62 is a refraction member which alters a focal position FP1 of a first optical path OP1. For example, a cylindrical optical glass is employed as the first refraction member 62. The first refraction member 62 may use various kinds of lenses, such as a plastic lens, a fluorite lens or an aspheric lens, other than the glass, as long as it can alter the focal position FP1 of the first optical path OP1.

The first optical path OP1 is an optical path which connects the image sensor 611, the lens 612 and the imaging reference mark 5M. As shown in Fig. 2, when the light is irradiated on the imaging reference mark 5M from the light source 64 (indicated by arrow L10), reflective light reflected by the imaging reference mark 5M passes through the first refraction member 62 and the lens 612 to arrive at the image sensor 611. In Fig. 2, the first optical path OP1 is schematically indicated by arrows L11 to L13. In the first optical path OP1, a focal position on the side of the imaging reference mark 5M is indicated as a focal position FP1 of the first optical path OP1, and a focal position on the side of the image sensor 611 is indicated as a focal position FP0 of the same. In the sucked-component position detection device 6, the focal position FP0 corresponds to a reference position of the height direction (indicated by arrow Z).

The first refraction member 62 is installed on the side of the base 8 (a side of the direction indicated by arrow Z1) and at a position lower than a focal position FP2 of a second optical path OP2. In this embodiment, the first refraction member 62 is loaded on an outer circumferential side of the lens 612. The second optical path OP2 is an optical path which connects the image sensor 611, the lens 612 and the sucked component PA1. As shown in Fig. 2, when the light is irradiated on the sucked component PA1 from the light source 64 (indicated by arrow L20), reflective light reflected by the sucked component PA1 passes through the lens 612 to arrive at the image sensor 611. In Fig. 2, the second optical path OP2 is schematically indicated by arrows L21 and L22. Moreover, in the second optical path OP2, a focal position on the side of the sucked component PA1 is indicated as the focal position FP2 of the second optical path OP2. A focal position on the side of the image sensor 611 is the same as the focal position FP0.

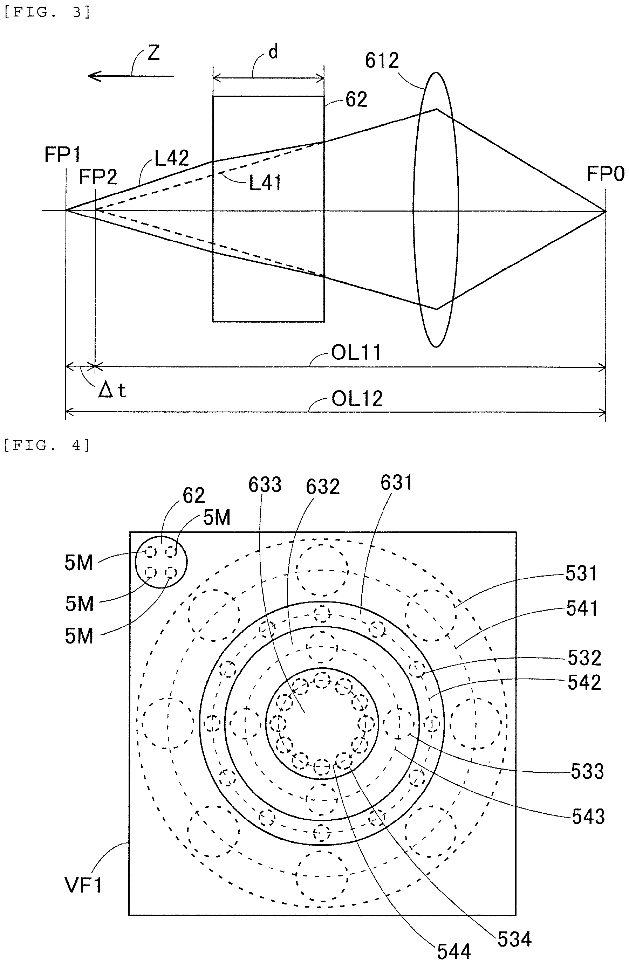

Fig. 3 is an explanation diagram illustrating a change in an optical length OL11 or an optical length OL12 depending on the presence or absence of the first refraction member 62. A dashed line L41 indicates an optical path when the first refraction member 62 is not installed between the imaging reference mark 5M and the lens 612. A solid line L42 indicates an optical path when the first refraction member 62 is installed between the imaging reference mark 5M and the lens 612. The focal positions FP0, FP1 and FP2 correspond to the focal positions FP0, FP1 and FP2, which are shown in Fig. 2. As shown in Fig. 3, since the light is refracted by the first refraction member 62, the focal position FP1 when the first refraction member 62 is installed moves in the direction of arrow Z as compared with the focal position FP2 when the first refraction member 62 is not installed. That is, the optical length OL12 of the optical path (corresponding to the first optical path OP1) from the focal position FP0 to the focal position FP1, which is indicated by the solid line L42, is longer than the optical length OL11 of the optical path (corresponding to the second optical path OP2) from the focal position FP0 to the focal position FP2, which is indicated by the dashed line L41. When a refraction index of the first refraction member 62 is n and a thickness (corresponding to thickness T62) of the first refraction member 62 in the height direction (indicated by arrow Z) is d, an increment $\Delta t$ of the optical length at this time can be expressed by the following equation 1.

$$(\mathrm{Equation}\ 1)$$

$$\Delta t\ =\ d\ (1-1/n)$$

When the first refraction member 62 is disposed between the imaging reference mark 5M and the lens 612, the first optical path OP1 has the optical length longer than the optical length when the first refraction member 62 is not disposed. That is, the focal position FP1 of the first optical path OP1 is set to a position higher than the focal position FP2 of the second optical path OP2 in the height direction (indicated by arrow Z). Therefore, it is possible to focus on the imaging reference mark 5M which is installed above the sucked component PA1 in the height direction (indicated by arrow Z). Thus, it is possible to focus on both the imaging reference mark 5M and the sucked component PA1 to simultaneously capture images of the imaging reference mark 5M and the sucked component PA1 in the same visual field.

In the present embodiment, the sucked-component position detection device 6 includes the first refraction member 62 for altering the focal position FP1 of the first optical path OP1 that connects the image sensor 611, the lens 612 and the imaging reference mark 5M. Therefore, it is possible to alter the focal position FP1 of the first optical path OP1 with respect to the imaging reference mark 5M installed at a height different than that of the sucked component PA1, thereby focusing on both the imaging reference mark 5M and the sucked component PA1.

Since the first refraction member 62 is installed at a position lower than the focal position FP2 of the second optical path OP2 that connects the image sensor 611, the lens 612 and the sucked component PA1, the first refraction member 62 and the sucked component PA1 do not collide with each other when the component-mounting head 52a moves to capture images in the longitudinal direction (indicated by arrow Y1) of Fig. 2. Therefore, it is not necessary to provide a mechanism for preventing collision of the first refraction member 62 with the sucked component PA1, thereby downsizing the sucked-component position detection device 6. This configuration is not limited to the sucked component PA1, but can be employed for other sucked components PA.

Since the first refraction member 62 is provided on the side of the base 8 (a side of the direction indicated by arrow Z1) of the component-mounting machine 1, a configuration of the component-mounting head 52a can be more simplified as compared with a case in which the first refraction member 62 is provided on the side of the component-mounting head 52a, thereby lightening the component-mounting head 52a.

(Second Refraction Member 63)

The sucked-component position detection device 6 may include the second refraction member 63. The second refraction member 63 is a refraction member which alters the focal position FP2 of the second optical path OP2, and can be formed by the same material as the first refraction member 62. The second refraction member 63 may be installed on the side of the base 8 (a side of the direction indicated by arrow Z1) and at a position lower than a focal position FP2 of a second optical path OP2. In the present embodiment, the second refraction member 63 is loaded on the lens 612, which is on an inner circumferential side than the first refraction member 62. As shown in Fig. 2, when the light is irradiated on the sucked component PA2 from the light source 64 (indicated by arrow L30), reflective light reflected by the sucked component PA2 passes through the second refraction member 63 and the lens 612 to arrive at the image sensor 611. In this case, the second optical path OP2 is indicated as the second optical path OP21. In Fig. 2, the second optical path OP21 is schematically indicated by arrows L31 to L33.

As shown in Fig. 2, the sucked component PA2 is positioned above the sucked component PA1 in the height direction (indicated by arrow Z). When the second refraction member 63 is disposed between the sucked component PA2 and the lens 612, the second optical path OP2 has the optical length longer than the optical length when the second refraction member 63 is not disposed. That is, the focal position FP21 of the second optical path OP21 is set to a position higher than the focal position FP2 of the second optical path OP2 in the height direction (indicated by arrow Z). Therefore, it is possible to focus on the sucked component PA2 which is positioned above the sucked component PA1 in the height direction (indicated by arrow Z). Thus, it is possible to focus on both the imaging reference mark 5M and the sucked component PA2 to simultaneously capture images of the imaging reference mark 5M and the sucked component PA2 in the same visual field. Since the imaging reference mark 5M is installed above any one of the sucked components PA in the height direction (indicated by arrow Z), the thickness T63 of the second refraction member 63 is set to be thinner than the thickness T62 of the first refraction member 62.

There is light that arrives at the image sensor 611 not via the first refraction member 62 among the reflective light reflected by the imaging reference mark 5M, and light that arrives at the image sensor 611 not via the second refraction member 63 among the reflective light reflected by the sucked component PA2. Due to these rays of light, a ghost may occur in the captured image. In the sucked-component position detection device 6 of the present embodiment, the aperture 613 of the imaging unit 61 is set such that, out of reflective light emitted from the light source 64 and reflected by the imaging reference mark 5M and the sucked component PA, mainly the light parallel to the height direction (indicated by arrow Z1) of the component-mounting machine 1 arrives at the image sensor 611. Therefore, it is possible to suppress a ghost occurrence in the captured images of the imaging reference mark 5M and the sucked component PA, thereby preventing false recognition when the positions of imaging reference mark 5M and the sucked component PA are recognized.

In the present embodiment, the sucked-component position detection device 6 includes the second refraction member 63 which alters the focal position FP2 of the second optical path OP2, thus it is possible to alter the focal position FP2 of the second optical path OP2 in accordance with a height of the sucked component PA2. Since the second refraction member 63 is installed on the side of the base 8 (a side of the direction indicated by arrow Z1) and at a position lower than a focal position FP2 of a second optical path OP2, it is possible to obtain a similar effect to the aforementioned effect of the first refraction member 62.

The component-mounting head 52 of the present embodiment is a rotary head in which a plurality of the suction nozzles 53 is rotatably held on a circumference of a circle concentrically provided with an axis line. The rotary head has a different circumferential diameter around which the suction nozzle 53 rotates depending on a size of the sucked component PA. For example, the rotary head for mounting a big-size sucked component PA keeps an interval between the sucked components PA by making the circumferential diameter around which the suction nozzle 53 rotates bigger as compared with the rotary head for mounting a small-size sucked component PA. Since the rotary head has the plurality of the suction nozzles 53, types of the sucked components PA sucked by the suction nozzles 53 may be different. When the types of the sucked components PA are different, the thickness of the sucked components PA will be different, thus the positions (heights) of the sucked components PA in the height direction (indicated by arrow Z) will be different.

That is, when the component-mounting heads 52 are different from each other, the circumferential diameters around which the suction nozzles 53 rotate will be different, and heights of the sucked components PA will be different. Therefore, it is necessary to set the focal position FP2 of the second optical path OP2 in accordance with the component-mounting head 52. In the present embodiment, three second refraction members 63 are concentrically arranged as viewed from the height direction (indicated by arrow Z1) in accordance with heights of the sucked components PA held by three component-mounting heads 52b to 52d, having different circumferential diameters around which the suction nozzles 53 rotate.

Fig. 4 is a plan view illustrating a state in what three second refraction members are concentrically arranged. In Fig. 4, the three second refraction members 63 are distinguished such that the second refraction member 63 arranged on an outermost circumferential side is indicated as the second refraction member 631, the second refraction member 63 arranged on an inner circumferential side of the second refraction member 631 is indicated as the second refraction member 632, and the second refraction member 63 arranged on an inner circumferential side of the second refraction member 632 is indicated as the second refraction member 633. The first refraction member 62 and the second refraction members 631 to 633 are loaded on the lens 612. The visual field of the imaging unit 61 is indicated as a region VF1.

In the case of the component-mounting heads 52a to 52d, the symbols 52a, 52b, 52c and 52d are allocated in a descending order of greatness of circumferential diameter around which the suction nozzle 53 rotates. The component-mounting heads 52a, 52b, 52c and 52d have the suction nozzles 531, 532, 533 and 534, respectively. In Fig. 4, the circumference around which the suction nozzle 531 rotates is a circumference 541, the circumference around which the suction nozzle 532 rotates is a circumference 542, the circumference around which the suction nozzle 533 rotates is a circumference 543, and the circumference around which the suction nozzle 534 rotates is a circumference 544. In Fig. 2, the component-mounting heads 52a and 52d are illustrated while the component-mounting heads 52b and 52c are omitted.

The second refraction member 631 has the focal position FP2 of the second optical path OP2, which is set in accordance with the height of the sucked component PA held by the component-mounting head 52b. The second refraction member 632 has the focal position FP2 of the second optical path OP2, which is set in accordance with the height of the sucked component PA held by the component-mounting head 52c. The second refraction member 633 has the focal position FP2 of the second optical path OP2, which is set in accordance with the height of the sucked component PA2 held by the component-mounting head 52d. As stated above, the focal length of the lens 612 is set in accordance with the height of the sucked component PA1 held by the component-mounting head 52a. When the component-mounting head 52a is used, the second refraction member 63 is not necessary.

In the present embodiment, three second refraction members 631 to 633 are concentrically arranged in accordance with heights of the sucked components PA held by three component-mounting heads 52b to 52d, having different circumferential diameters around which the suction nozzles 53 rotate. Therefore, it is possible to set the focal position FP2 of the second optical path OP2 in accordance with heights of the sucked components PA of each of the component-mounting heads 52b to 52d, respectively. Moreover, it is unnecessary to replace the second refraction member 63 every time the component-mounting head 52 is replaced, thereby decreasing manhours.

(Light Source 64)

The light source 64 can irradiate the imaging reference mark 5M and the sucked component PA with light. As the light source 64, for examples, a publicly-known light-emitting diode (LED) may be used, and wavelength of the emitted light is not limited. As shown in Fig. 2, when the component-mounting head 52 arrives above the sucked-component position detection device 6, the control device 7 outputs an imaging-start signal to the imaging unit 61 and the light source 64. When the imaging-start signal is output, the light source 64 irradiates the imaging reference mark 5M and the sucked component PA with light during an exposure time of the imaging unit 61. The imaging unit 61 captures images of the imaging reference mark 5M and the sucked component PA simultaneously. While the component-mounting head 52 moves in the longitudinal direction (indicated by arrow Y1) without stopping above the sucked-component position detection unit 6, the imaging unit 61 captures images of the imaging reference mark 5M and the sucked component PA simultaneously.

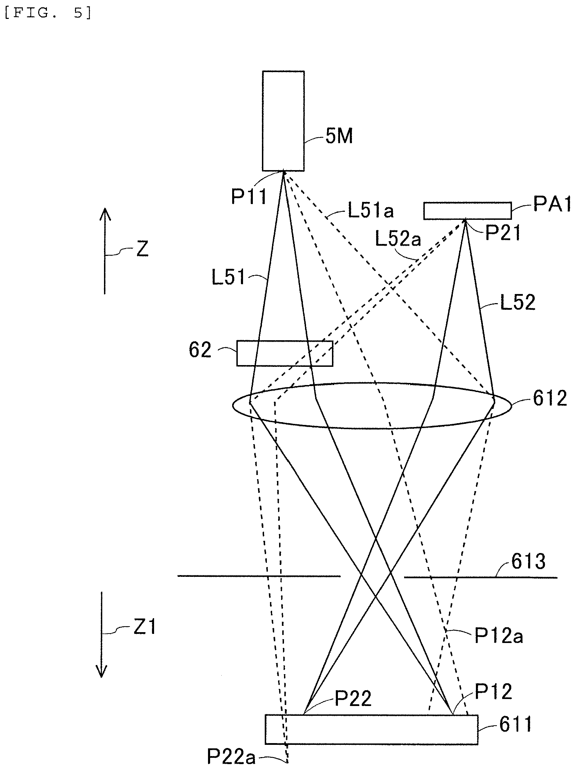

Fig. 5 is an explanation diagram illustrating a correlation between transmission of reflective light and the aperture 613 of the imaging unit 61. A solid line L51 indicates an optical path of light arrived at the image sensor 611 via the first refraction member 62 among reflective light reflected by the imaging reference mark 5M. The optical path indicated by the solid line L51 has a focal point P11 on the side of the imaging reference mark 5M, and a focal point P12 on the side of the image sensor 611. A dashed line L51a indicates an optical path of light arrived at the image sensor 611 not via the first refraction member 62 among reflective light reflected by the imaging reference mark 5M. The optical path indicated by the dashed line L51a has a focal point P11 on the side of the imaging reference mark 5M, and a focal point P12a on the side of the image sensor 611.

A solid line L52 indicates an optical path of light arrived at the image sensor 611 not via the first refraction member 62 among reflective light reflected by the sucked component PA1. The optical path indicated by the solid line L52 has a focal point P21 on the side of the sucked component PA1, and a focal point P22 on the side of the image sensor 611. A dashed line L52a indicates an optical path of light arrived at the image sensor 611 via the first refraction member 62 among reflective light reflected by the sucked component PA1. The optical path indicated by the dashed line L52a has a focal point P21 on the side of the sucked component PA1, and a focal point P22a on the side of the image sensor 611.

As indicated by the dashed line L51a, there is light arrived at the image sensor 611 not via the first refraction member 62 among reflective light reflected by the imaging reference mark 5M. The position of the focal point P12a of the optical path indicated by the dashed line L51a is different from that of the optical path indicated by the solid line L51, and deviates from an imaging area of the image sensor 611. Therefore, reflective light of the optical path indicated by the dashed line L51a is guided to a position deviated from the focal point P12 within the imaging area of the image sensor 611, thereby generating the ghost in the captured image. As indicated by the dashed line L52a, there is light arrived at the image sensor 611 via the first refraction member 62 among reflective light reflected by the sucked component PA1. The position of the focal point P22a of the optical path indicated by the dashed line L52a is different from that of the optical path indicated by the solid line L52, and deviates from the imaging area of the image sensor 611. Therefore, reflective light of the optical path indicated by the dashed line L52a is guided to a position deviated from the focal point P22 within the imaging area of the image sensor 611, thereby generating the ghost in the captured image.

In the present embodiment, the imaging unit 61 has the aperture 613 which is set such that, out of reflective light emitted from the light source 64 and reflected by the imaging reference mark 5M and the sucked component PA1, mainly the light parallel to the height direction (indicated by arrow Z1) of the component-mounting machine 1 arrives at the image sensor 611. That is, the aperture 613 blocks reflective light of the optical path indicated by the dashed line L51a, which is different from the optical path indicated by the solid line L51, and reflective light of the optical path indicated by the dashed line L52a, which is different from the optical path indicated by the solid line L52. Therefore, it is possible to suppress a ghost occurred in the captured images of the imaging reference mark 5M and the sucked component PA1, thereby preventing false recognition when the positions of imaging reference mark 5M and the sucked component PA1 are recognized. In Fig. 5, the description is omitted for convenience of explanation, but the similar effect can be obtained for light arrived at the image sensor 611 not via the second refraction member 63 among reflective light reflected by the sucked component PA2. Moreover, the similar effect can be obtained for light arrived at the image sensor 611 via the second refraction member 63 among reflective light reflected by the imaging reference mark 5M or the sucked component PA1.

In the present embodiment, the first refraction member 62 and the second refraction member 63 are installed on the side of the imaging unit 61 rather than the light source 64 which irradiates the imaging reference mark 5M and the sucked component PA with light. Therefore, it is possible to prevent the light, emitted from the light source 64, from being guided directly to the first refraction member 62 and the second refraction member 63 and being reflected by the first refraction member 62 and second refraction member 63. Thus, it is possible to prevent the reflective light from causing an adverse effect on imaging of the imaging reference mark 5M and the sucked component PA.

(Image Processing Unit 65)

The image processing unit 65 processes the images of the imaging reference mark 5M and the sucked component PA, which are captured by the imaging unit 61, and calculates the position of the sucked component PA with respect to the imaging reference mark 5M. The memory of the control device 7 stores a legitimate holding position of each sucked component PA with respect to the imaging reference mark 5M in advance. The image processing unit 65 matches the imaging reference mark 5M stored in the memory and the imaging reference mark 5M captured by the imaging unit 61. The image processing unit 65 calculates positional displacement and angle deviation of each sucked component PA by comparing the legitimate holding position stored in the memory and a holding position captured by the imaging unit 61. Based on the calculated results, such as positional displacement and angle deviation, the mounting position of the sucked component PA is calibrated.

(3) Others

The present invention is not limited to embodiment as stated above and illustrated in accompanying drawings, but may be modified and implemented appropriately without departing from the scope of the invention. For example, the embodiment shows three second refraction members 63 which are concentrically arranged. However, a number of the second refraction members 63 is not limited to 3; it can be appropriately modified in accordance with a circumferential diameter around which the suction nozzle 53 rotates.

Moreover, a shape of the second refraction member 63 is not limited to a concentric circle. For example, cylindrical second refraction members 63 may be scattered on a portion corresponding to the suction nozzles 532 to 534 as shown in Fig. 4. In the embodiment, three second refraction members 631 to 633 are loaded on the lens 612. However, it is possible to load the second refraction member 63 corresponding to the used component-mounting head 52 on the lens 612. When the component-mounting head 52 is replaced, the second refraction member 63 may be replaced at the same time.

Reference Signs List

1:    component-mounting machine,
52:    component-mounting head,
53:    suction nozzle, 5M: imaging reference mark,
6:    sucked-component position detection unit,
61:    imaging unit, 611: image sensor, 612: lens,
62:    first refraction member,
63:    second refraction member,
64:    light source,
OP1:    first optical path, OP2: second optical path,

**Claims**

1. A component-mounting machine (1), comprising:

   a component-mounting head (52a to 52d) having a suction nozzle (531 to 534) which is configured to suck a component (PA1, PA2) to mount on a substrate; and
   a sucked-component position detection device (6) which is configured to capture images of an imaging reference mark (5M) provided on the component-mounting head (52a to 52d) and the sucked component (PA1, PA2) sucked by the suction nozzle (531 to 534) simultaneously to detect a position of the sucked component (PA1, PA2) with respect to the imaging reference mark (5M), wherein
   the sucked-component position detection device (6) is provided only on a base side of the component-mounting machine (1) and includes an imaging unit (61) which has an image sensor (611) and a lens (612),
   **characterized in that**
   the sucked-component position detection device (6) further includes a first refraction member (62) which is configured to alter a focal position (FP1) of a first optical path (OP1) that connects the image sensor (611), the lens (612) and the imaging reference mark (5M), wherein the first refraction member (62) is provided at a position lower than a focal position (FP2, FP21) of a second optical path (OP2, OP21) that connects the image sensor (611), the lens (612) and the sucked component (PA1, PA2).

2. The component-mounting machine according to claim 1, wherein
   the sucked-component position detection device further includes a second refraction member (631 to 633) which is configured to alter the focal position (FP, FP1) of the second optical path (OP, OP21), and the second refraction member is provided at a position lower than the focal position (FP2, FP21) of the second optical path (OP2, OP21).

3. The component-mounting machine according to claim 2, wherein
   the component-mounting head (52a to 52d) is a rotary head in which a plurality of suction nozzles (531 to 534) are rotatably held on a circumference of one circle whose center is located on an axis line of the component-mounting head (52a to 52d), and a plurality of second refraction members (631 to 633) are concentrically arranged in accordance with heights of sucked components (PA1, PA2), sucked by the suction nozzles (531 to 534) of a corresponding plurality of component-mounting rotary heads (52a to 52d) which have different circumferential diameters.

4. The component-mounting machine according to any one of claims 1 to 3, wherein
   the sucked-component position detection device (6) further includes a light source (64) which is configured to irradiate the imaging reference mark (5M) and the sucked components (PA1, PA2) with light, and
   the first refraction member (62) is provided on the imaging unit (61) and at a position lower than the lowermost portion of the light source (64).

5. The component-mounting machine according to any one of claims 1 to 4, wherein
   the sucked-component position detection device (6) further includes a light source (64) which is configured to irradiate the imaging reference mark (5M) and the sucked component (PA1, PA2) with light, and
   the imaging unit (61) has an aperture which is set such that, out of reflective light emitted from the light source (64) and reflected by the imaging reference mark (5M) and the sucked component (PA1, PA2), light parallel to a height direction of the component-mounting machine (1) arrives at the image sensor (611).

**Patentansprüche**

1. Maschine zur Montage von Komponenten (1), umfassend:

   einen Kopf (52a bis 52d) zur Montage von Komponenten, der eine Saugdüse (531 bis 534) aufweist, die konfiguriert ist, eine Komponente (PA1, PA2) anzusaugen, die auf einem Substrat montiert wird; und
   eine Positionserfassungsvorrichtung einer angesaugten Komponente (6), die konfiguriert ist, Bilder einer Abbildungsbezugsmarke (5M), die auf dem Kopf zur Montage von Komponenten (52a bis 52d) vorgesehen ist, und der angesaugten Komponente (PA1, PA2), die von der Saugdüse (531 bis 534) angesaugt wird, gleichzeitig aufzunehmen, damit eine Position der angesaugten Komponente (PA1, PA2) bezüglich der Abbildungsbezugsmarke (5M) erfasst wird, wobei
   die Positionserfassungsvorrichtung einer angesaugten Komponente (6) nur an einer Basisseite der Maschine zur Montage von Komponenten (1) bereitgestellt ist und eine Abbildungseinheit (61) aufweist, die mit einem Bildsensor (611) und einer Linse (612) versehen ist,
   **dadurch gekennzeichnet, dass**
   die Positionserfassungsvorrichtung einer angesaugten Komponente (6) weiterhin ein erstes Brechungselement (62) umfasst, das konfiguriert ist, eine Fokuslage (FP1) eines ersten optischen Pfades (OP1) zu ändern, der den Bildsensor (611), die Linse (612) und die Abbildungsbezugsmarke (5M) verbindet, wobei das erste Brechungselement (62) an einer Position angeordnet ist, die niedriger als eine Fokusposition (FP2, FP21) eines zweiten optischen Pfades (OP2, OP21) ist, der den Bildsensor (611), die Linse (612) und die angesaugte Komponente (PA1, PA2) verbindet.

2. Die Maschine zur Montage von Komponenten nach Anspruch 1, wobei
die Positionserfassungsvorrichtung einer angesaugten Komponente ferner ein zweites Brechungselement (631 bis 633) umfasst, das konfiguriert ist, die Fokuslage (FP, FP1) des zweiten optischen Pfades (OP2, OP21) zu ändern, und
das zweite Brechungselement an einer Position angeordnet ist, die niedriger als die Fokusposition (FP2, FP21) des zweiten optischen Pfades (OP2, OP21) ist.

3. Die Maschine zur Montage von Komponenten nach Anspruch 2, wobei
der Kopf zur Montage von Komponenten (52a bis 52d) ein rotierender Kopf ist, in dem eine Vielzahl von Saugdüsen (531 bis 534) drehbar an einem Umfang eines Kreises gehalten sind, dessen Mittelpunkt auf einer Achse des Kopfes zur Montage von Komponenten (52a bis 52d) liegt, und indem eine Vielzahl von zweiten Brechungselementen (631 bis 633) konzentrisch gemäß Höhen der angesaugten Komponenten (PA1, PA2) angeordnet sind, die durch die Saugdüsen (531 bis 534) einer entsprechenden Vielzahl von rotierenden Köpfen zur Montage von Komponenten (52a bis 52d) angesaugt werden, die mit unterschiedlichen Durchmessern versehen sind.

4. Die Maschine zur Montage von Komponenten nach einem der Ansprüche 1 bis 3, wobei
die Positionserfassungsvorrichtung einer angesaugten Komponente (6) ferner eine Lichtquelle (64) umfasst, die konfiguriert ist, die Abbildungsbezugsmarke (5M) und die angesaugten Komponenten (PA1, PA2) mit Licht auszustrahlen, und
das erste Brechungselement (62) an der Abbildungseinheit (61) und an einer Position angeordnet ist, die niedriger als der unterste Abschnitt der Lichtquelle (64) ist.

5. Die Maschine zur Montage von Komponenten nach einem der Ansprüche 1 bis 3, wobei
die Positionserfassungsvorrichtung einer angesaugten Komponente (6) ferner eine Lichtquelle (64) umfasst, die konfiguriert ist, die Abbildungsbezugsmarke (5M) und die gesaugte Komponente (PA1, PA2) mit Licht auszustrahlen, und
die Abbildungseinheit (61) mit einer Öffnung versehen ist, die so eingestellt ist, dass Licht parallel zu einer Höhenrichtung der Maschine zur Montage von Komponenten (1) bei dem Bildsensor (61) ankommt, im Gegensatz zu einem reflektierenden Licht, das von der Lichtquelle (64) emittiert wird und von der Abbildungsbezugsmarke (5M) und der angesaugten Komponente (PA1, PA2) reflektiert wird.

## Revendications

1. Machine de montage de composants (1), comprenant :

une tête de montage de composants (52a à 52d) comportant une buse d'aspiration (531 à 534) qui est configurée pour aspirer un composant (PA1, PA2) à monter sur un substrat ; et
un dispositif de détection de position du composant aspiré (6) qui est configuré pour capturer simultanément des images d'un repère de référence pour l'imagerie (5M) pourvu sur la tête de montage de composants (52a à 52d) et du composant aspiré (PA1, PA2) aspiré par la buse d'aspiration (531 à 534) afin de détecter la position du composant aspiré (PA1, PA2) par rapport au repère de référence pour l'imagerie (5M), dans lequel
le dispositif de détection de position du composant aspiré (6) est pourvu uniquement sur un côté de base de la machine de montage de composants (1) et comprend une unité d'imagerie (61) qui comporte un capteur d'images (611) et une lentille (612),
**caractérisée en ce que**
le dispositif de détection de position du composant aspiré (6) comprend en outre un premier élément de réfraction (62) qui est configuré pour altérer la position focale (FP1) d'un premier chemin optique (OP1) qui connecte le capteur d'images (611), la lentille (612) et le repère de référence pour l'imagerie (5M), dans laquelle
le premier élément de réfraction (62) est pourvu à une position plus basse que la position focale (FP2, FP21) d'un deuxième chemin optique (OP2, OP21) qui connecte le capteur d'images (611), la lentille (612) et le composant aspiré (PA1, PA2).

2. Machine de montage de composants selon la revendication 1, dans laquelle
le dispositif de détection de position du composant aspiré comprend en outre un deuxième élément de réfraction (631 à 633) qui est configuré pour altérer la position focale (FP, FP1) du deuxième chemin optique (OP, OP21), et

le deuxième élément de réfraction est pourvu à une position plus basse que la position focale (FP2, FP21) du deuxième chemin optique (OP2, OP21).

3. Machine de montage de composants selon la revendication 2, dans laquelle

la tête de montage de composants (52a à 52d) est une tête rotative dans laquelle les buses d'une pluralité de buses d'aspiration (531 à 534) sont supportées de manière rotative sur la circonférence d'un cercle dont le centre se trouve sur une ligne d'axe de la tête de montage de composants (52a à 52d), et les éléments d'une pluralité de deuxièmes éléments de réfraction (631 à 633) sont agencés concentriquement conformément aux hauteurs de composants aspirés (PA1, PA2), aspirés par les buses d'aspiration (531 à 534) d'une pluralité correspondante de têtes rotatives de montage de composants (52a à 52d) qui présentent différents diamètres circonférentiels.

4. Machine de montage de composants selon l'une quelconque des revendications 1 à 3, dans laquelle

le dispositif de détection de position du composant aspiré (6) comprend en outre une source de lumière (64) qui est configurée pour irradier le repère de référence pour l'imagerie (5M) et les composants aspirés (PA1, PA2) avec de la lumière, et le premier élément de réfraction (62) est pourvu sur l'unité d'imagerie (61) et à une position plus basse que la portion la plus basse de la source de lumière (64).

5. Machine de montage de composants selon l'une quelconque des revendications 1 à 4, dans laquelle

le dispositif de détection de position du composant aspiré (6) comprend en outre une source de lumière (64) qui est configurée pour irradier le repère de référence pour l'imagerie (5M) et le composant aspiré (PA1, PA2) avec de la lumière, et l'unité d'imagerie (61) comporte une ouverture qui est configurée de telle sorte que, dans la lumière réfléchissante émise par la source de lumière (64) et réfléchie par le repère de référence pour l'imagerie (5M) et le composant aspiré (PA1, PA2), la lumière parallèle à une direction en hauteur de la machine de montage de composants (1) arrive sur le capteur d'images (611).

[FIG. 1]

[FIG. 2]

[FIG. 3]

[FIG. 4]

[FIG. 5]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001518723 A
- JP 2005197564 A
- US 2002031279 A1
- WO 2004046643 A1
- WO 0217352 A2